Europäisches Patentamt

European Patent Office

Office européen des brevets

(11) Veröffentlichungsnummer: **0 269 845 B1**

(12) **EUROPÄISCHE PATENTSCHRIFT**

(45) Veröffentlichungstag der Patentschrift: **15.04.92**

(21) Anmeldenummer: **87115679.0**

(22) Anmeldetag: **26.10.87**

(51) Int. Cl.⁵: **A61N 1/08**, H03K 5/02

(54) **Endverstärker für Reizstromgerät.**

(30) Priorität: **07.11.86 DE 3637943**

(43) Veröffentlichungstag der Anmeldung:
**08.06.88 Patentblatt 88/23**

(45) Bekanntmachung des Hinweises auf die
Patenterteilung:
**15.04.92 Patentblatt 92/16**

(84) Benannte Vertragsstaaten:
**AT BE CH DE FR LI NL**

(56) Entgegenhaltungen:
FR-A- 2 500 689
US-A- 3 312 833
US-A- 3 885 569

**HOROWITZ & HILL, "The Art of Electronics",
1st Edition, 1980, Cambridge, US, Seite 102**

(73) Patentinhaber: **SIEMENS AKTIENGESELL-
SCHAFT
Wittelsbacherplatz 2
W-8000 München 2(DE)**

(72) Erfinder: **Herzog, Ludwig
Drei-Thorn-Strasse 3
W-6948 Waldmichelbach(DE)**
Erfinder: **Knapp, Volker
Pestalozzistrasse 19
W-6948 Waldmichelbach(DE)**

Rank Xerox (UK) Business Services

# Beschreibung

Die Erfindung bezieht sich auf einen Endverstärker für ein Reizstromgerät, der eine Leistungsstufe mit eingangsseitiger Begrenzertransistorenschaltung und ausgangsseitiger Leistungstransistorenschaltung und eine vorgeschaltete Treiberstufe mit ausgangsseitiger Stromquellentransistorenschaltung sowie einen der Treiberstufe vorgeschalteten Regeldifferenzverstärker umfaßt.

Endverstärker dieser Art umfassen gewöhnlich eine Treiberstufe mit nachgeschalteter Leistungsstufe. Zur Regelung bei Konstantstrombetrieb (CC) dient ein eingangsseitiger Regeldifferenzverstärker, dessen Eingang mit dem Ausgang der Leistungsstufe über eine Widerstandsanordnung gegengekoppelt ist. Ändert sich der Strom am Ausgang der Leistungsstufe, so wird die Änderung zum Regeldifferenzverstärker also gegengekoppelt, der diese dann ausregelt.

Würde ein solcher Endverstärker nun für Konstantspannungsbetrieb eingesetzt, so ergäbe sich das folgende Problem: Bei rasch steigendem Strom (z.B. Kurzschluß an den Elektroden, rasch sinkendem Patientenwiderstand etc.) geht die Spannung zwischen den Emittern der Eingangsstrombegrenzungstransistoren der Leistungsstufe rasch gegen Null. Der starke Spannungsabfall würde auf den Eingang des Regeldifferenzverstärkers rückgekoppelt werden und von dort mit einem Versuch der Ausregelung des starken Spannungsabfalls (Kurzschlußausregelung) beantwortet werden. Durch die steigende Eingangsspannung gerät die Leistungsstufe aber sehr rasch ins Schwingen und seine Transistoren werden zerstört.

Aus der US-A-3 312 833 ist ein Endverstärker bekannt, der eine Leistungsendstufe und eine vorgeschaltete Treiberstufe mit einem ausgangsseitigen Stromquellentransistor sowie einen der Treiberstufe vorgeschalteten Regeldifferenzverstärker umfaßt. Der Ausgang des Stromquellentransistors ist einerseits über einen Verstärkungsgradeinsteller mit einem Eingang des Regeldifferenzverstärkers und andererseits mit der Leistungsendstufe verbunden. Bei dem bekannten Endverstärker weist die Leistungsendstufe Transistoren auf, die mit der KollektorEmitter-Strecke dieser Transistoren in Reihe geschaltet sind und daher den aus der Leistungsstufe entnehmbaren maximalen Laststrom bestimmen (begrenzen). Durch diese bekannte Art der Strombegrenzung erhöht sich aber in unerwünschter Weise die Ausgangsimpedanz der Leistungsstufe. Deshalb ist eine zusätzliche Rückkopplung zwischen dem Ausgang der Leistungsstufe und einem Eingang des Regeldifferenzverstärkers erforderlich.

Aus der Druckschrift Horowitz/Hill, "The art of Electronics", 1st Edition, 1980, Cambridge, Seite 102, ist es bekannt, den Steueranschluß eines Leistungstransistors über einen ohmschen Widerstand mit dem Ausgang eines Operationsverstärkers zu verbinden. Um bei Gegenstrom einem Basis-Emitter-Durchbruch am Leistungstransistor vorzubeugen, ist zu der Basis-Emitter-Strecke eine Diode antiparallel geschaltet.

Aufgabe vorliegender Erfindung ist es, bei einem Endverstärker der eingangs genannten Art Mittel vorzusehen, die einen Konstantspannungsbetrieb ohne die Gefahr der Schwingungserzeugung oder einer Transistorzerstörung erlauben.

Beim Endverstärker gemäß der Erfindung sorgt die Strombegrenzerschaltung zwischen Treiberstufe und Leistungsstufe dafür, daß die Spannung am Ausgang der Stromquellentransistorschaltung auch bei Kurzschluß am Ausgang der Leistungsstufe nicht ebenfalls gegen Null geht, sondern als mögliche Regelspannung erhalten bleibt. Im Konstantspannungsbetrieb ist also immer noch hinreichend Regelspannung vorhanden, so daß eine Kurzschlußausregelung mit allen zuvor beschriebenen negativen Folgen vermieden wird.

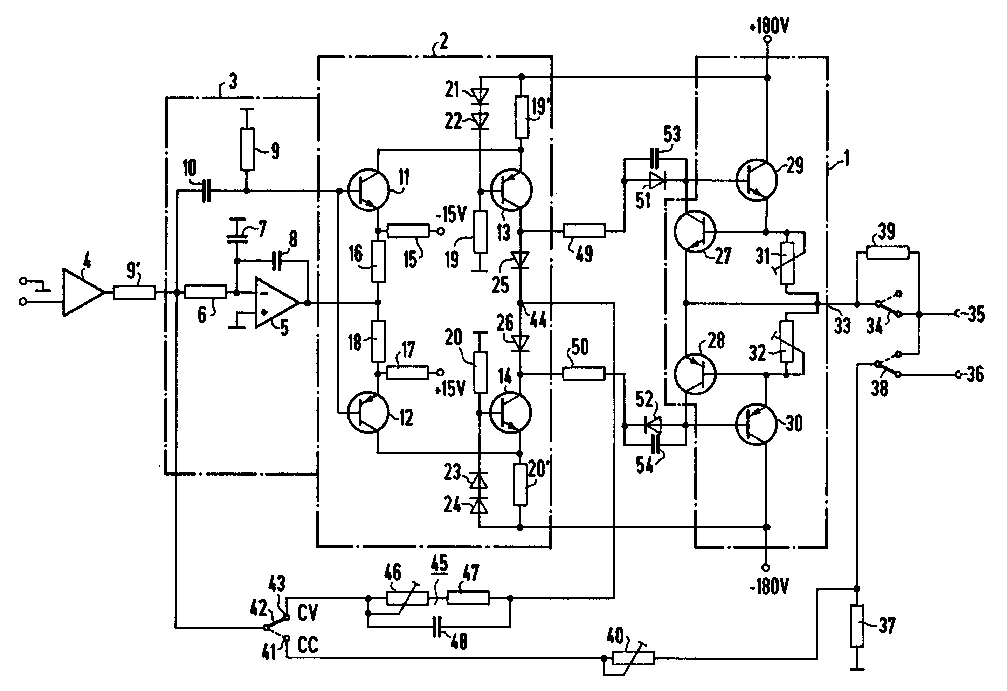

Weitere Vorteile und Einzelheiten der Erfindung ergeben sich aus der nachfolgenden Beschreibung eines Ausführungsbeispiels anhand der Zeichnung und in Verbindung mit den Unteransprüchen.

Die Figur zeigt ein Schaltbild des erfindungsgemäßen Endverstärkers.

Wie dargestellt, umfaßt der Endverstärker (Gegentaktendverstärker) eine Leistungsstufe 1, eine vorgeschaltete Treiberstufe 2 und einen eingangsseitigen Regeldifferenzverstärker 3. Das Bauelement 4 ist ein Vorverstärker.

Der Regeldifferenzverstärker umfaßt einen Operationsverstärker 5, der mit einem ohmschen Widerstand 6 und Kondensatoren 7, 8 beschaltet ist. Die Bauelemente 9, 9' und 10 sind ohmsche Widerstände bzw. ein Kondensator.

Die Treiberstufe 2 beinhaltet Regeltransformiertransistoren 11, 12 und Stromquellentransistoren 13, 14, die im Gegentakt geschaltet sind (für Bipolarbetrieb des Reizstromgerätes). Die Bauelemente 15 bis 20 sind ohmsche Widerstände und die Bauelemente 21 bis 26 sind Dioden.

Die Leistungsstufe 1 umfaßt ebenso im Gegentakt geschaltete Strombegrenzungstransistoren 27, 28 und Leistungstransistoren 29, 30. Die Bauelemente 31, 32 sind Strommeßwiderstände am Ausgang 33 der Leistungsstufe 1.

Gemäß der Figur kann der Ausgang 33 der Leistungsstufe 1 über einen Relaiskontakt 34 mit der einen Elektrodenanschlußbuchse 35 verbunden werden. Die zweite Elektrodenanschlußbuchse 36 liegt einerseits über einen niederohmigen (z.B. 22 Ohm) Strommeßwiderstand 37 an Masse und ist andererseits über einen weiteren Relaiskontakt 38 im Falle der Abschaltung des inneren Stromkreises des Reizstromgerätes (gestrichelte Stellung des Kontaktes 34) kurzschlußmäßig mit der Elektrodenanschlußbuchse 35 verbindbar. Das Element 39 ist ein ohmscher Testwiderstand. Der Strommeßwiderstand 37 ist über ein Potentiometer 40 mit dem Schaltkontakt 41 für Konstantstrombetrieb (CC) eines Umschalters 42 verbunden.

Bei Konstantspannungsbetrieb (CV) befindet sich der Umschalter 42 in der gezeigten Stellung am Schaltkontakt 43. In dieser Schaltstellung ist gemäß der Erfindung der Ausgang 44 der Treiberstufe 2 zwischen den beiden Dioden 25, 26 über ein Verstärkungsgradeinstellglied 45 mit dem Eingang des Regeldifferenzverstärkers 3 verbunden. Das Verstärkungsgradeinstellglied 45 umfaßt dabei ein Potentiometer 46, einen ohmschen Festwiderstand 47 und einen Kondensator 48.

Darüber hinaus sind gemäß der Erfindung aber auch noch die Kollektoren der Stromquellentransistoren 13, 14 in der Treiberstufe 2 über ohmsche Strombegrenzungswiderstände 49, 50 (z.B. 1k Ω ) sowie Dioden 51, 52 mit parallelgeschalteten Kondensatoren 53, 54 mit den Kollektoren der Strombegrenzungstransistoren 27, 28 und den Basen der Leistungstransistoren 29, 30 verbunden. Die Strombegrenzungswiderstände 49, 50 sorgen für einen Spannungsabfall bei Kurzschluß am Ausgang der Leistungsstufe 1. Damit sinkt die Spannung am Ausgang 44 der Treiberstufe niemals auf Null. Es verbleibt immer ein hinreichendes Maß an Restspannung, die als Regelspannung im Sinne der Erfindung gegengekoppelt werden kann.

Die Dioden 51, 52 verhindern Gegenstrombetrieb der Transistoren 27, 28, 29, 30 der Leistungsstufe 1 im ungünstigsten Falle.

## Patentansprüche

1. Endverstärker für ein Reizstromgerät, der eine Leistungsstufe (1) mit eingangsseitiger Begrenzertransistorenschaltung (27, 28) und ausgangsseitiger Leistungstransistorenschaltung (29, 30) und eine vorgeschaltete Treiberstufe (2) mit ausgangsseitiger Stromquellentransistorenschaltung (13, 14) sowie einen der Treiberstufe (2) vorgeschalteten Regeldifferenzverstärker (3) umfaßt, wobei die Stromquellentransistorenschaltung (13, 14) der Treiberstufe (2) ausgangsseitig über eine Strombegrenzungsschaltung (49 bis 54) mit der Begrenzertransistorenschaltung (27, 28) und Leistungstransistorenschaltung (29, 30) der Leistungsstufe (1) verbunden ist und wobei ein an der Strombegrenzungsschaltung (49 bis 54) entstehender Spannungsabfall als gegenkoppelnde Regelspannung ausgangsseitig an der Treiberstufe (2) entnommen und über einen Verstärkungsgradeinsteller (45) mit einem Eingang des Regeldifferenzverstärkers (3) verbindbar ist.

2. Endverstärker nach Anspruch 1, **dadurch gekennzeichnet,** daß die Strombegrenzungsschaltung ohmsche Widerstände (49, 50) zur Erzeugung eines begrenzenden Spannungsabfalls umfaßt.

3. Endverstärker nach Anspruch 2, **dadurch gekennzeichnet,** daß die Strombegrenzungsschaltung auch noch Dioden (51, 52) umfaßt, die in dem Sinne gepolt sind, daß ein Gegenstrombetrieb der Transistoren (27 bis 30) der Leistungsstufe verhindert wird.

4. Endverstärker nach einem der Ansprüche 1 oder 3, **dadurch gekennzeichnet,** daß der Endverstärker zwischen Konstantstrom- und Konstantspannungsbetrieb umschaltbar ist und daß die an der Strombegrenzungsschaltung (49 bis 54) entnommene Regelspannung nur im Konstantspannungsbetrieb mit dem Eingang des Regeldifferenzverstärkers (3) verbunden ist.

## Claims

1. Final amplifier for a stimulating current unit which comprises a power stage (1) with a limiter transistor circuit arrangement (27, 28) on the input side and a power transistor circuit arrangement (29, 30) on the output side and a previously connected driver stage (2) with a current source transistor circuit arrangement (13, 14) on the output side and also a regulation difference amplifier (3) previously connected to the driver stage (2), with the current source transistor circuit arrangement (13, 14) of the driver stage (2) being connected on the output side by way of a current-limiting circuit arrangement (49 to 54) with the limiter transistor circuit arrangement (27, 28) and power transistor circuit arrangement (29, 30) of the power stage (1), and with a voltage drop, which develops at the current-limiting circuit arrangement (49 to 54), being drawn as a negative feedback regulating voltage on the output side at the driver stage (2) and being capable of being connected with an input of the regulation difference amplifier (3) by way of an amplification-degree adjuster (45).

2. Final amplifier according to claim 1, characterised in that the current-limiting circuit arrangement comprises ohmic resistors (49, 50) for generating a limiting voltage drop.

3. Final amplifier according to claim 2, characterised in that the current-limiting circuit arrangement also further comprises diodes (51, 52) which are poled in the sense that a counter-current operation of the transistors (27 to 30) of the power stage is prevented.

4. Final amplifier according to one of the claims 1 or 3, characterised in that the final amplifier can be switched over between constant current and constant voltage operation and in that the regulating voltage which is drawn at the current-limiting circuit arrangement (49 to 54) is only connected with the input of the regulation difference amplifier (3) during constant voltage operation.

**Revendications**

1. Amplificateur final pour un appareil à courant de stimulation stimulateur, qui comporte un étage de puissance (1) possédant un circuit limiteur à transistors (27,28) situé côté entrée et un circuit à transistors de puissance (29,30) situé côté sortie, et un étage d'attaque (2) branché en amont et comportant un circuit à transistors formant source de courant (13,14) côté sortie ainsi qu'un amplificateur (3) d'une différence de réglage, branché en amont de l'étage d'attaque (2), et dans lequel le circuit à transistors formant source de courant (13,14) de l'étage d'attaque (2) est raccordé, côté sortie, par l'intermédiaire d'un circuit de limitation de courant (49 à 54), au circuit limiteur à transistors (27,28) et au circuit à transistors de puissance (29,30) de l'étage de puissance (1), et dans lequel une chute de tension, qui apparaît dans le circuit de limitation de courant (49 à 54), est prélevée côté sortie sur l'étage d'attaque (2) en tant que tension de réglage de contre-réaction et peut être appliquée par un régulateur (45) du degré d'amplification à une entrée de l'amplificateur (3) de la différence de réglage.

2. Amplificateur final suivant la revendication 1, caractérisé par le fait que le circuit de limitation de courant comporte des résistances ohmiques (49,50) servant à produire une chute de tension limitative.

3. Amplificateur final suivant la revendication 2, caractérisé par le fait que le circuit de limitation de courant comprend en outre également des diodes (51,52), qui sont polarisées dans un sens empêchant un fonctionnement à contre-courant des transistors (27 à 30) de l'étage de puissance.

4. Amplificateur final suivant l'une des revendications 1 ou 3, caractérisé par le fait que l'amplificateur final peut être commuté entre un fonctionnement à courant constant et un fonctionnement à tension constante et que la tension de réglage, prélevée dans le circuit de limitation de courant (49 à 54), est appliquée uniquement dans le fonctionnement à tension constante, à l'entrée de l'amplificateur (3) de la différence de réglage.